# EUROPEAN PATENT APPLICATION

(11) **EP 4 239 410 A1**
(43) Date of publication of application: **06.09.2023**
(21) Application number: 22159521.8
(22) Date of filing: 01.03.2022
(51) Int. Cl.: G03F 7/20

(54) **RETICLE STAGE**

(71) Applicant: ASML Netherlands B.V., 5500 AH Veldhoven (NL)
(72) Inventor: VAN DE KERKHOF, Marcus, Adrianus, 5500 AH Veldhoven (NL); BUSTRAAN, Krijn, Frederik, 5500 AH Veldhoven (NL)
(74) Representative: ASML Netherlands B.V.

(57) **Abstract**

A reticle stage for an EUV lithographic apparatus is disclosed. The reticle stage comprises a support for a reflective reticle, and at least one shielding element coupled to the support. The at least one shielding element is selectively configurable between a first position for shielding a portion of a patterned side of the reflective reticle from an EUV radiation beam, and a second position for exposing the portion. A corresponding method of operating an EUV lithographic apparatus is also disclosed.

## Description

### FIELD

The present invention relates to a reticle stage for an EUV lithographic apparatus, and in particular to a stage configurable for shielding a portion of a reflective reticle from an EUV radiation beam.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In some examples, the patterning device may be provided with alignment marks, which may be used to align the patterning device relative to the substrate in the lithographic apparatus, during an exposure process.

However, it has been discovered that such alignment marks may be inadvertently patterned onto the substrate during an exposure process, e.g. patterned onto neighbouring field of a target field on the substrate.

Known lithographic apparatuses may be provided with one or more shields or masks to prevent such inadvertent patterning. Use of such shields or mask is known in the art as "Reticle Masking", or more commonly as "ReMa".

To be effective at preventing the alignment marks from being patterned onto neighbouring fields on the substrate, such shields or masks may require accurate positioning with precise timing within the lithographic apparatus. However, known means for controlling positioning and/or timing of such shields or masks may be large, complex, costly. Furthermore, increasing scan speeds and accelerations of the shields or masks may require larger and heavier modules to provide such speeds and accelerations. However, space to implement such large modules within a lithographic apparatus may be limited. For example, due to optical requirements, such modules may be disposed immediately below a patterning device in a lithographic apparatus, where space may be limited. Furthermore, control and maintenance of such modules may incur costs, and may increase of downtime of a lithograph apparatus.

It is therefore desirable to provide a low costs and low complexity reticle stage having with effective means for preventing patterning device alignment marks from being inadvertently patterned onto a substrate during an exposure process.

It is therefore an aim of at least one embodiment of at least one aspect of the present disclosure to obviate or at least mitigate at least one of the above identified shortcomings of the prior art.

### SUMMARY

According to a first aspect of the disclosure, there is provided a reticle stage for an EUV lithographic apparatus, the reticle stage comprising: a support for a reflective reticle; and at least one shielding element coupled to the support and selectively configurable between a first position for shielding a portion of a patterned side of the reflective reticle from an EUV radiation beam, and a second position for exposing the portion.

Advantageously, by having the at least one shielding element coupled to the support, the at least one shielding element may be configured to be moved together with the support within the lithographic apparatus, thereby mitigating a requirement to precisely synchronise movement of the shielding element with movement of the support.

Furthermore, when in the first position the at least one shielding element may block patterned beams of radiation, e.g. radiation patterned by the reflective reticle. That is, in the first position the at least one shielding element may block both patterned and non-patterned beams of radiation.

The at least one shielding element may comprise at least one elongate member. The at least one elongate member may be selectively pivotable or rotatable between the first position and the second position. The second position may be substantially perpendicular to the first position.

The reticle stage may comprise a pair of shielding elements. Each shielding element may be configurable to selectively shield a respective portion of ends, e.g. opposite ends, of the patterned side of the reflective reticle.

Advantageously, each shielding element may be configured to shield reticle alignment marks, which may typically be located at, at least, end portions at opposite ends of a reticle. As such, inadvertent patterning of the reticle alignment marks onto the substrate W during an exposure process may be avoided.

The at least one shielding element may be coupled to the support such that, in use, the at least one element may move together with the support within the lithographic apparatus.

The reticle stage may comprise an actuator configured to transition the at least one shielding element between the first and second positions. The at least one shielding element may be disposed at an opposite side of the support to the actuator.

Advantageously, by disposing the shielding element at an opposite side of the support to the actuator, contamination of the reticle may be minimized, such as by debris from the actuator. That is, a key benefit of disposing the shielding element at an opposite side of the support to the actuator is that, in some examples, motors and bearings of the actuator may be disposed on a backside of the stage, far away from the sensitive reticle front side, thereby reducing reticle defectively.

The actuator may be configurable to move the reticle stage within the lithographic apparatus.

The at least one shielding element may comprise a fluid channel. The fluid channel may be for thermally conditioning the at least one shielding element.

In use, the at least one shielding element may be prone to heating due to absorption of EUV radiation for exposing a substrate. The provision of fluid channels for thermally conditioning the at least one shielding element may prevent such heating, thus also preventing possible damage and/or displacement of the reticle due to thermal expansion and/or contraction of the at least one shielding element.

The reticle stage may comprise a system for inducing a flow of fluid in the fluid channel.

The reticle stage may be configured for loading or unloading a reflective reticle onto or from the support respectively when the at least one shielding element may be in the second position.

A reticle-facing surface of the at least one shielding element may be curved.

Advantageously, a curved surface may reduce or minimise a contact area between the reticle and the at least one shielding element, such as when the reticle is caught by the at least one shielding element, as described in more detail below.

A/the reticle-facing surface of the at least one shielding element may be configured to support the reticle upon detachment of the reticle from the support.

That is, the reticle-facing surface of the at least one shielding element may be configured to catch the reticle upon detachment of the reticle from the support, such as by failure of an electrostatic clamp of the support. As such, the at least one shielding element may double as a reticle catcher, e.g. perform a primary function of shielding patterned and/or non-patterned beams of radiation as described above and an additional secondary function of catching the reticle upon detachment of the reticle from the support.

In a cross section orthogonal to a plane defined by the support, the at least one shielding element may comprise a substantially triangular cross-section.

Advantageously, such a cross-section may substantially reduce absorption by the at least one shielding element of the EUV radiation for exposing a substrate. By reducing the absorption, heating of the at least one shielding element may be minimised.

In a cross section orthogonal to a plane defined by the support, surfaces of a shielding portion of the at least one shielding element that are configured to face away from the patterned side of the reflective reticle in use may be configured to limit absorption of a portion of the EUV radiation beam for patterning a substrate.

The reticle stage may be provided in combination with the reflective reticle. The/each portion may correspond to at least one reticle alignment mark located in a border portion of the patterned side of the reflective reticle.

According to a second aspect of the disclosure, there is provided a lithographic apparatus comprising the reticle stage according to the first aspect.

According to a third aspect of the disclosure, there is provided a lithographic system comprising an EUV radiation source and a lithographic apparatus according to the second aspect.

According to a fourth aspect of the disclosure, there is provided a method of operating an EUV lithographic apparatus.

The method comprises determining a relative position and/or orientation of a reticle on a support of a reticle stage by sensing radiation reflected from at least one reticle alignment mark on a patterned side of the reflective reticle.

The method comprises configuring at least one shielding element coupled to the support to transition from a position for exposing the at least one reticle alignment mark to a position for shielding the at least one reticle alignment mark from an EUV radiation beam.

The method comprises exposing the reflective reticle to EUV radiation, wherein radiation reflected from the reflective reticle is for patterning a substrate.

The above summary is intended to be merely exemplary and non-limiting. The disclosure includes one or more corresponding aspects, embodiments or features in isolation or in various combinations whether or not specifically stated (including claimed) in that combination or in isolation. It should be understood that features defined above in accordance with any aspect of the present disclosure or below relating to any specific embodiment of the disclosure may be utilized, either alone or in combination with any other defined feature, in any other aspect or embodiment or to form a further aspect or embodiment of the disclosure.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a layout of a prior art reflective reticle;
- Figure 3 depicts a prior art reticle stage with Reticle Masking (ReMA) blades;
- Figure 4a depicts a reticle stage according to an embodiment of the disclosure, with a pair of shielding elements in a second position for exposing a portion of a reflective reticle;
- Figure 4b depicts the reticle stage of Figure 4a, with the pair of shielding elements in a first position for shielding the portion of the reflective reticle;
- Figure 5 depicts a triangular cross-section of a shielding element and a corresponding graph depicting a reflectivity of the shielding element;
- Figure 6 is a block diagram of a cross-section of an example of a reticle stage, according to an embodiment of the disclosure; and
- Figure 7 is a flow diagram of a method of operating an EUV lithographic apparatus.

### DETAILED DESCRIPTION

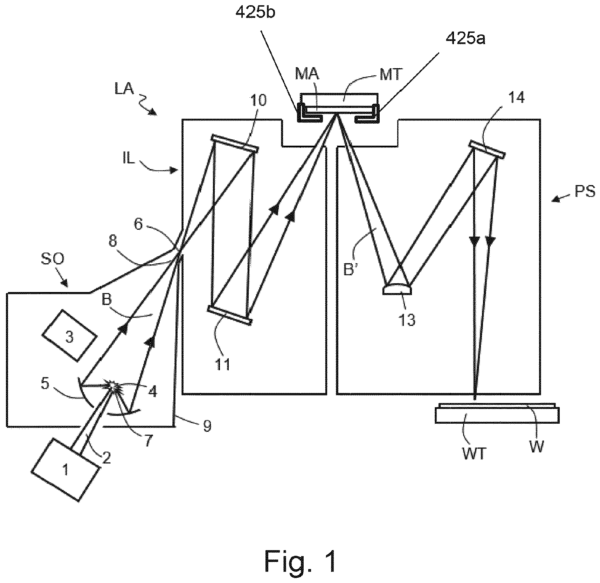

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask or reticle), a projection system PS and a substrate table WT configured to support a substrate W.

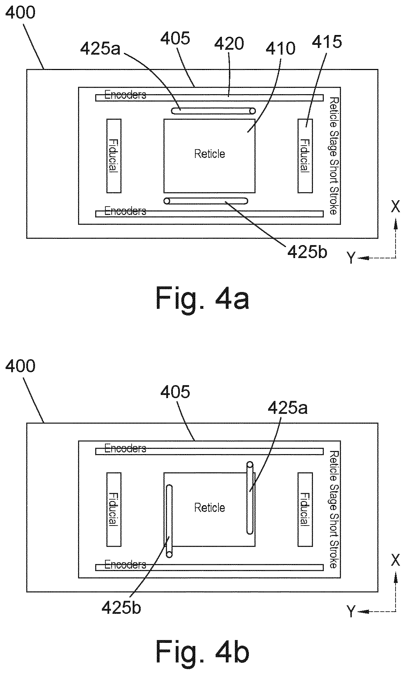

In the example of Figure 1, the support structure MT is depicted with a first shielding element 425a and a second shielding element 425b. Each shielding element 425a, 425b is coupled to the support structure MT and selectively configurable between a first position for shielding a portion of a patterned side of the patterning device MA, e.g. a reflective reticle, from an EUV radiation beam, and a second position for exposing the portion. The first shielding element 425a and the second shielding element 425b, and operation thereof, is described in more detail below, in particular with reference to Figures 4a and 4b.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO2 laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

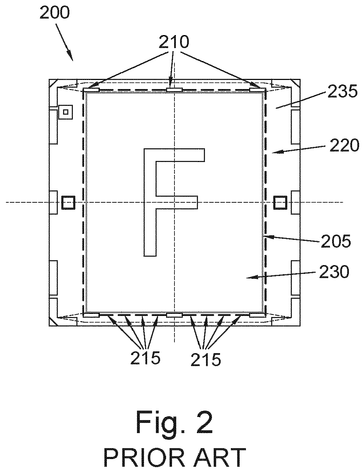

Figure 2 depicts an example layout of a prior art reflective reticle 200, e.g. patterning device MA.

A pattern to be patterned to the substrate W is indicated as field 230, and may be known in the art as an 'imaging field'.

Field 230 is surrounded by an image border 205, which in some examples may correspond to an area without patterns present. Around an outside of the image border 205 is a border portion 235 extending to a perimeter of the reflective reticle 200. Within the border portion 235 are a plurality of reticle alignment marks.

For example, along a top potion and a bottom of the field 230 are Transmission Image Sensors Reticle Blue Alignment (TIS-RBA) marks 210. Each TIS-RBA mark 210 may, for example, comprise a plurality of marks or patterns that may be used for alignment and/or positioning of the reflective reticle 200 on the reticle stage MA, and also alignment and/or positioning of the reflective reticle 200 relative to a substrate W.

Also shown for purposes of example and for completeness are a plurality of Transmission Image Sensor horizontal Reticle Shape Correction (TIS-hRSC) marks 215 disposed along a top potion and a bottom of the field 230. A plurality of Transmission Image Sensor vertical Reticle Shape Correction (TIS-vRSC) 220 marks is also depicted at each side of the field 230.

The TIS-RBA marks 210, and in some instances also the TIS-vRSC marks 220 and TIS-hRSC marks 215 may collectively and/or individually be generally termed "reticle alignment marks".

That is, in use, an optical source, e.g. a laser, may direct radiation at one or more of the reticle alignment marks, and radiation reflected from the one or more reticle alignment marks may indicate a relative position and/or orientation of the reflective reticle 200. That is, reticle alignment marks, e.g. TIS RBA marks 210, are used for alignment of the reticle 200 to the substrate W, prior to exposures.

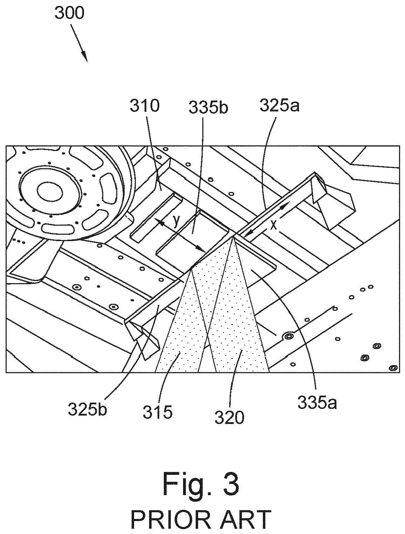

Subsequently, during scanning exposures, such reticle alignment marks must be shielded to prevent inadvertent patterning of the reticle alignment marks onto the substrate W during the exposure process. Existing lithographic apparatuses implement masking of the reticle alignment marks using a system of Reticle Masking (ReMa) blades, as described in more detail with reference to Figure 3.

It will be appreciated that the reflective reticle 200 of Figure 2 is provided as an example of reticle alignment marks used on a reticle, and other implementations may be used with the disclosed reticle stage.

Figure 3 depicts a prior art reticle stage 300 with ReMa blades 325a, 325b, 335a, 335b in operation in a lithographic apparatus.

A reticle, e.g. patterning device MA, is disposed on a support 310, e.g. support structure MT. The support 310 is configured to be moved in direction denoted as a 'y' direction in Figure 3. Movement of the support 310 is synchronised with corresponding movement of a substrate to be patterned, e.g. movement of substrate table WT configured to support a substrate W.

During an exposure process, EUV radiation beam 315, e.g. beam B, is directed at the reticle. The EUV radiation beam 315 interacts with the reticle. As a result of this interaction, a patterned EUV radiation beam 320, e.g. beam B', is generated.

During movement of the support 310, first ReMa blades 325a, 325b are configured to move in a direction denoted as an 'x' direction in Figure 3, orthogonal to the 'y' direction. The first ReMa blades 325a, 325b are configured to mask reticle alignment marks on the reticle. Operation of the first ReMa blades 325a, 325b must be highly synchronised with the movement of the support 310.

During movement of the support 310, second ReMa blades 335a, 335b are configured to move the 'y' direction. The second ReMa blades 335a, 335b are also configured to mask reticle alignment marks on the reticle. Operation of the second ReMa blades 335a, 335b must be highly synchronised with the movement of the reticle stage 300.

Existing ReMa systems are amongst the heaviest and most complex modules of the a lithographic apparatus' scanner system, and may prove to be a limiting factor for increasing scan speeds in state-of the art and future lithographic apparatuses.

Figures 4a and 4b depict a reticle stage 400 for an EUV lithographic apparatus, according to an embodiment of the disclosure.

The reticle stage 400 comprises a support 405 for a reflective reticle 410.

For purposes of illustration only, the support 405 is depicted as comprising fiducial markers 415 and encoders 420. The fiducial markers 415 and encoders 420 may, for example, comprise reflective elements used to determine a level of degradation of the reticle 410 in use, and/or an orientation and/or position of the support 405.

The example reticle stage 400 comprises a first shielding element 425a. The first shielding element 425a is coupled to the support 405.

In the example described herein, the reticle stage 400 also comprises a second shielding element 425b. The second shielding element 425b is also coupled to the support 405. In other embodiments, only a single shielding element 425a or 425b may be provided.

The first shielding element 425a and the second shielding element 425b are selectively configurable between a first position for shielding a portion of a patterned side of the reflective reticle 410 from an EUV radiation beam, and a second position for exposing the portion.

Figure 4b depicts the reticle stage 400 wherein the first shielding element 425a and the second shielding element 425b are in the first position for shielding a portion of a patterned side of the reflective reticle 410 from an EUV radiation beam.

Figure 4a depicts the reticle stage 400 wherein the first shielding element 425a and the second shielding element 425b are in the second position for exposing the portion to the EUV radiation beam.

Each of the first shielding element 425a and the second shielding element 425b comprise an elongate member, e.g. an arm. In the example of Figures 4a and 4b, each of the first shielding element 425a and the second shielding element 425b is pivotable between the first position and the second position. In the second position each of the first shielding element 425a and the second shielding element 425b is substantially perpendicular to the first shielding element 425a and the second shielding element 425b when in the first position. Each of the first shielding element 425a and the second shielding element 425b are configurable to selectively shield a respective portion of ends, e.g. opposite ends, of the patterned side of the reflective reticle 410.

Advantageously, because the shielding elements 425a and 425b are coupled to the support 405, in use the shielding elements 425a and 425b move together with the support 405 within the lithographic apparatus, e.g. in the y-direction. For reference, the x-direction is denoted by axis 'X' in Figures 4a and 4b, and the y-direction is denoted by axis 'Y'. The x-direction and the y-direction of Figures 4a and 4b correspond to the x-direction and the y-direction of Figure 3. In use, the 'y' direction corresponds to a scanning direction, e.g. a direction in which the support 405 may undergo substantial accelerations and decelerations, thereby inducing substantial G-forces.

The portion of the reticle 410 that is shielded by the shielding elements 425a and 425b when in the first position may correspond to at least one reticle alignment mark located in a border portion of the patterned side of the reflective reticle 410. For example, referring again to the example reticle 200 of Figure 2, the portion of the reticle 410 that is shielded by the shielding elements 425a and 425b when in the first position may comprise TIS-RBA marks 210 and TIS-hRSC marks 215.

In an example configuration, the shielding elements 425a and 425b may have an approximate width in the region of 1 to 2 millimeters. In an example configuration, the shielding elements 425a and 425b may have an approximate length in the region of the reticle width, e.g. 150 millimeters in some examples.

Referring again to the reticle stage 300 of Figure 3, in embodiments of the disclosure the 'y-blades', e.g. ReMa blades 335a, 335b, may be effectively replaced by the disclosed shielding elements 425a and 425b that are configurable between the described first position and second position. Furthermore, 'x-blades', e.g. ReMa blades 325a and 325 may in some embodiments be configured as static blades, e.g. in a fixed position relative to the reticle support.

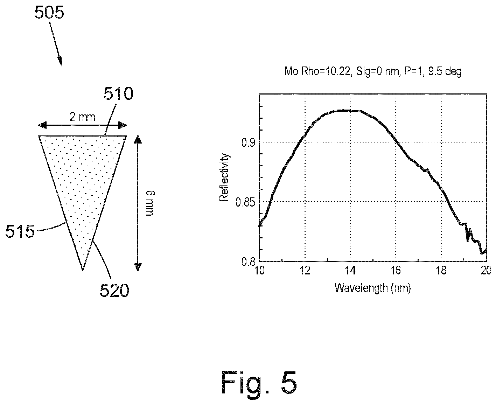

Figure 5 depicts a cross-section of an example shielding element 505. The shielding element 505 may correspond to one or both of the first shielding element 425a and the second shielding element 425b of Figures 4a and 4b.

The shielding element 505 is depicted as having a triangular cross-section. In use, surfaces of the shielding element 505 that face away from the patterned side of the reflective reticle, or at least a shielding portion of the shielding element 505, are advantageously configured to limit absorption of a portion of the EUV radiation beam towards the substrate.

For example, a first surface 510 of the example shielding element 505 may face towards the the patterned side of the reflective reticle in use, e.g. reflective reticle 410. As described in more detail below, in some embodiments the first surface 510 may be curved. A second surface 515 and a third surface 520 may substantially face away from the patterned side of the reflective reticle in use, and may be provided at an angle relative to the reflective reticle to limit absorption of EUV radiation, and thus minimize heating of the example shielding element 505.

Dimensions provided in Figure 5, e.g. first surface 510 having a width of 2 millimeters and a height of the triangular cross-section being 6 millimeter, are provided only for purposes of example. Such example dimensions may suppress EUV absorption by greater than 90%, wherein reflected EUV radiation may be configured to be directed to dark parts of the reticle, e.g. non patterned part of the reticles. Such dark parts of the reticle may relatively harmlessly absorb the radiation.

Furthermore, the example shielding element 505 may be formed from a material, such as Molybdenum, that is relatively stable against EUV radiation and H-plasma. The example shielding element 505 may be formed with a relatively smooth surface.

Also depicted in Figure 5 is a graph depicting a resultant reflectivity of the example shielding element 505. In the example, the shielding element 505 is formed from Molybdenum. It can be seen that a peak reflectivity occurs for radiation having a wavelength of around 13.5 um, which corresponds to the wavelength of EUV radiation used for patterning the substrate.

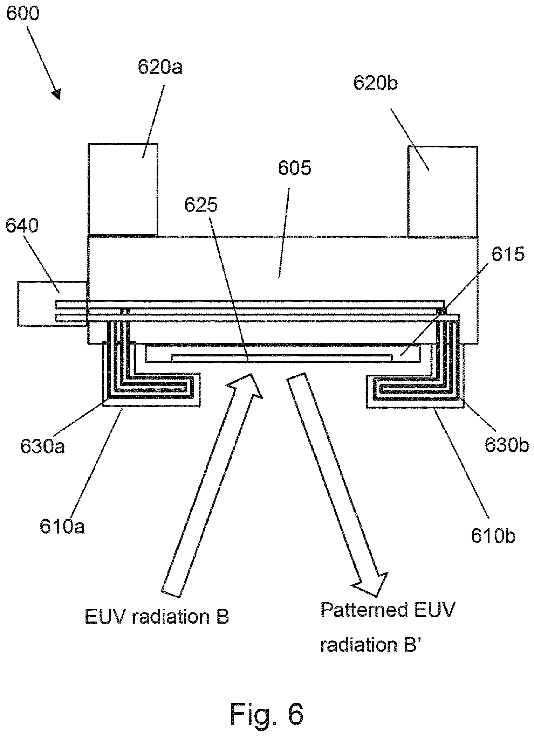

Figure 6 is a block diagram of a cross-section of an example of a reticle stage 600 for an EUV lithographic apparatus, according to an embodiment of the disclosure.

The example reticle stage 600 comprises a support 605, which is depicted as supporting a reflective reticle 615 comprising a pattern 625 for patterning a substrate in a lithographic process. The support 605 may, for example, be an electrostatic clamp.

Also depicted is a first shielding element 610a and a second shielding element 610b coupled to the support 605. The first shielding element 610a and a second shielding element 610b may correspond to the first shielding element 425a and the second shielding element 425b of Figures 4a and 4b. Similarly, in some embodiments, the first shielding element 610a and a second shielding element 610b may have a substantially triangular cross-section, e.g. as depicted with respect to the example shielding element 505 of Figure 5.

The first shielding element 610a and the second shielding element 610b are selectively configurable, e.g. pivotable, between a first position for shielding a portion of a patterned side of the reflective reticle 615 from an EUV radiation beam B, and a second position for exposing the portion.

When in the first position, the first shielding element 610a and the second shielding element 610b may block patterned beams of radiation, e.g. radiation patterned by the reflective reticle such as radiation beam B'. That is, in the first position, the first shielding element 610a and the second shielding element 610b may block both patterned beams of radiation B and non-patterned beams of radiation B'.

A first actuator 620a is configured to transition the first shielding element 610a between the first and second positions. A second actuator 620b is configured to transition the second shielding element 610b between the first and second positions.

Although the example reticle stage 600 depicts two distinct actuators 620a, 620b, in other examples a single actuator may be configured to actuate both of the first shielding element 610a and the second shielding element 610b between the first and second positions. In some embodiment the first actuator 620a and/or second actuator 620b, or the single actuator as described above, may also be configured to move the reticle stage within the lithographic apparatus, e.g. to move the reticle in synchronization with movement of the substrate.

Advantageously, the shielding elements 610a, 610b are disposed at an opposite sides of the support 605 to their respective actuators 620a, 620b.

In example reticle stage 600, the first shielding element 610a comprises a first fluid channel 630a and the second shielding element 610b comprise a second fluid channel 630b. The fluid channels 630a, 630b may be provided for thermally conditioning the respective shielding elements 610a, 610b. That is, in use a flow of thermally conditioned fluid, e.g. a liquid or a gas, may be induced in the fluid channels 630a, 630b to limit heating of the shielding elements 610a, 610b due to absorption of EUV radiation during an exposure process. In some example embodiments, the fluid may be water. In other examples, the fluid may be CO2.

The reticle stage 600 may comprise a system 640, such as a pump, for inducing the flow of fluid in the fluid channels 630a, 630b. In other examples, some or all of the system 640 may be provided elsewhere within the lithographic apparatus.

As can be seen in Figure 6, the first shielding element 610a and the second shielding element 610b extend below the reticle 615 when the shielding elements 610a, 610b are in the first position for shielding a portion of a patterned side of the reflective reticle 615 from an EUV radiation beam B. As such, reticle-facing surfaces of the shielding elements 610a, 610b are configured to support, e.g. catch, the reticle 615 upon detachment of the reticle 615 from the support 605. That is, a reticle-facing surface of each shielding element 610a, 610b is configured to support the reticle 615 upon detachment, e.g. accidental detachment, of the reticle 615 from the support 605. That is, the first shielding element 610a and/or the second shielding element 610b may provide a safety feature of catching the reticle 615 following accidental detachment of the reticle 615 from the support 605.

In some examples, the reticle-facing surface of each shielding element 610a, 610b may be curved, e.g. generally convex, such that the damage to the reticle 615 when the reticle 615 is caught by the shielding elements 610a, 610b is limited. That is, referring again to Figure 5, in some examples first surface 510 of the example shielding element 505 may be provided as a substantially curved surface to minimise contact area between the shielding elements 610a, 610b and the delicate reticle.

When the first shielding element 610a and the second shielding element 610b are in the second position, the reticle stage 600 may configured for loading or unloading the reflective reticle 615 onto or from the support 605 respectively.

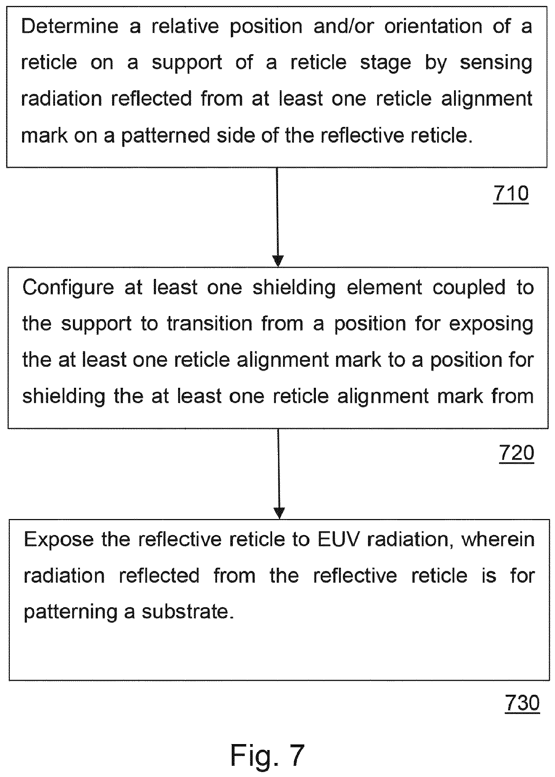

Figure 7 depicts a method of operating an EUV lithographic apparatus. A first step 710 comprises determining a relative position and/or orientation of a reticle on a support of a reticle stage by sensing radiation reflected from at least one reticle alignment mark on a patterned side of the reflective reticle. For example, referring again to Figure 2, TIS RBA marks may be used for alignment of the reticle 200 to the substrate W, prior to exposures.

A second step 720 comprises configuring at least one shielding element coupled to the support to transition from a position for exposing the at least one reticle alignment mark to a position for shielding the at least one reticle alignment mark from an EUV radiation beam. For example, at least one shielding element may correspond to the first shielding element 405a and the second shielding element 405b of Figure 4.

A third step comprises exposing the reflective reticle to EUV radiation, wherein radiation reflected from the reflective reticle is for patterning a substrate. Due to the at least one shielding element residing in the position for shielding the at least one reticle alignment mark from an EUV radiation beam inadvertent patterning onto the substrate of the at least one reticle alignment mark during the exposure process may be avoided.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A reticle stage for an EUV lithographic apparatus, the reticle stage comprising:
a support for a reflective reticle; and
at least one shielding element coupled to the support and selectively configurable between a first position for shielding a portion of a patterned side of the reflective reticle from an EUV radiation beam, and a second position for exposing the portion.

2. The reticle stage of claim 1, wherein the at least one shielding element comprises at least one elongate member selectively pivotable or rotatable between the first position and the second position, wherein the second position is substantially perpendicular to the first position.

3. The reticle stage of claim 1 or 2 comprising a pair of shielding elements, each shielding element configurable to selectively shield a respective portion of opposite ends of the patterned side of the reflective reticle.

4. The reticle stage of any preceding claim, wherein the at least one shielding element is coupled to the support such that, in use, the at least one element moves together with the support within the lithographic apparatus.

5. The reticle stage of any preceding claim comprising an actuator configured to transition the at least one shielding element between the first and second positions, wherein the at least one shielding element is disposed at an opposite side of the support to the actuator.

6. The reticle stage of claim 5, wherein the actuator is configurable to move the reticle stage within the lithographic apparatus.

7. The reticle stage of any preceding claim, wherein the at least one shielding element comprises a fluid channel for thermally conditioning the at least one shielding element.

8. The reticle stage of claim 7, comprising a system for inducing a flow of fluid in the fluid channel.

9. The reticle stage of any preceding claim, wherein the reticle stage is configured for loading or unloading a reflective reticle onto or from the support respectively, when the at least one shielding element is in the second position.

10. The reticle stage of any preceding claim, wherein:
a reticle-facing surface of the at least one shielding element is curved and/or
a/the reticle-facing surface of the at least one shielding element is configured to support the reticle upon detachment of the reticle from the support.

11. The reticle stage of any preceding claim, wherein in a cross section orthogonal to a plane defined by the support at least one of:
the at least one shielding element comprises a substantially triangular cross-section;
surfaces of a shielding portion of the at least one shielding element that are configured to face away from the patterned side of the reflective reticle in use are configured to limit absorption of a portion of the EUV radiation beam for patterning a substrate.

12. The reticle stage of any preceding claim in combination with the reflective reticle, wherein the/each portion corresponds to at least one reticle alignment mark located in a border portion of the patterned side of the reflective reticle.

13. A lithographic apparatus comprising the reticle stage of any preceding claim.

14. A lithographic system comprising an EUV radiation source and a lithographic apparatus according to claim 13.

15. A method of operating an EUV lithographic apparatus, the method comprising:
- determining a relative position and/or orientation of a reticle on a support of a reticle stage by sensing radiation reflected from at least one reticle alignment mark on a patterned side of the reflective reticle; and
- configuring at least one shielding element coupled to the support to transition from a position for exposing the at least one reticle alignment mark to a position for shielding the at least one reticle alignment mark from an EUV radiation beam; and
- exposing the reflective reticle to EUV radiation, wherein radiation reflected from the reflective reticle is for patterning a substrate.
